(19)

**Europäisches Patentamt**
**European Patent Office**
**Office européen des brevets**

(11) **EP 1 745 300 B1**

(12) **EUROPÄISCHE PATENTSCHRIFT**

(45) Veröffentlichungstag und Bekanntmachung des Hinweises auf die Patenterteilung:
**31.05.2017 Patentblatt 2017/22**

(21) Anmeldenummer: **05729365.6**

(22) Anmeldetag: **21.04.2005**

(51) Int Cl.:
***G01R 15/24*** (2006.01)

(86) Internationale Anmeldenummer:
**PCT/CH2005/000221**

(87) Internationale Veröffentlichungsnummer:
**WO 2005/111633 (24.11.2005 Gazette 2005/47)**

(54) **FASEROPTISCHE SENSORSPULE UND STROM- ODER MAGNETFELDSENSOR**

FIBER OPTICAL SENSOR COIL AND CURRENT- OR MAGNETIC FIELD SENSOR

BOBINE DE DETECTION EN FIBRE OPTIQUE ET CAPTEUR DE COURANT OU DE CHAMP MAGNÉTIQUE

(84) Benannte Vertragsstaaten:
**AT BE BG CH CY CZ DE DK EE ES FI FR GB GR HU IE IS IT LI LT LU MC NL PL PT RO SE SI SK TR**

(30) Priorität: **13.05.2004 EP 04405308**

(43) Veröffentlichungstag der Anmeldung:
**24.01.2007 Patentblatt 2007/04**

(73) Patentinhaber: **ABB Research Ltd.**
**8050 Zürich (CH)**

(72) Erfinder:
• **BOHNERT, Klaus**
**CH-5452 Oberrohrdorf (CH)**
• **GABUS, Philippe**
**CH-5415 Nussbaumen (CH)**
• **NEHRING, Juergen**
**CH-5430 Wettingen (CH)**
• **BRÄNDLE, Hubert**
**CH-8102 Oberengstringen (CH)**

(74) Vertreter: **ABB Patent Attorneys**
**c/o ABB Schweiz AG**
**Intellectual Property CH-IP**
**Brown Boveri Strasse 6**
**5400 Baden (CH)**

(56) Entgegenhaltungen:
**EP-A- 0 856 737    WO-A-94/00768**

• **PATENT ABSTRACTS OF JAPAN Bd. 2000, Nr. 20, 10. Juli 2001 (2001-07-10) -& JP 2001 083187 A (FUJI ELECTRIC CO LTD), 30. März 2001 (2001-03-30)**
• **PATENT ABSTRACTS OF JAPAN Bd. 1997, Nr. 07, 31. Juli 1997 (1997-07-31) -& JP 09 068618 A (TOSHIBA CORP), 11. März 1997 (1997-03-11)**
• **PATENT ABSTRACTS OF JAPAN Bd. 2000, Nr. 07, 29. September 2000 (2000-09-29) -& JP 2000 121675 A (TOKYO ELECTRIC POWER CO INC:THE; FUJI ELECTRIC CO LTD), 28. April 2000 (2000-04-28)**

**Beschreibung**

Technisches Gebiet

Die Erfindung bezieht sich auf das Gebiet der faseroptischen Sensorik. Sie bezieht sich auf einen Sensorkopf, einen Strom- oder Magnetfeldsensor und eine Hochspannungsanlage sowie ein Verfahren zur Herstellung eines Sensorkopfes gemäss dem Oberbegriff der unabhängigen Patentansprüche.

Stand der Technik

Ein derartiger Sensorkopf ist beispielsweise aus EP 0'856'737 A1 bekannt. Dort ist ein faseroptischer Stromsensor beschrieben mit einem Sensorkopf, der eine in einer Kapillare angeordnete Sensorfaser beinhaltet, die eine Sensorspule bildet. Die Sensorfaser ist von ihrer Faserschutzhülle befreit und danach thermisch behandelt, um mechanische Spannungen auszuheilen, die zu störenden Einflüssen durch ungewollte Doppelbrechung führen. Dadurch wird eine verbesserte Temperaturstabilität der Sensormessungen erreicht. In die Kapillare ist ein Schutzgas oder auch ein Öl zu dem Zwecke eingebracht, das Eindringen von Feuchtigkeit oder chemisch aggressiven Dämpfen in das Kapillareninnere zu verhindern, wodurch die faserschutzhüllenfreie Sensorfaser chemisch beschädigt werden könnte.

Ein solcher Sensorkopf hat den Nachteil, dass seine Sensorfaser nicht flexibel ist. Die Sensorspule hat somit keine variable, sondern eine feste, vorgegebene Form. Zur Messung eines in einem Stromleiter fliessenden elektrischen Stromes kann deshalb der Sensor nicht montiert werden, ohne den Stromleiter zu öffnen. Im Falle grosser Spulendurchmesser ist eine feste Spulenform auch für Transport und Montage von Nachteil. Würde man die Spule eines derartigen Sensors flexibel gestalten, würde sich dies nachteilig auf seine Genauigkeit auswirken. Eine stabile Messempfindlichkeit wäre nicht gewährleistet.

Weiterhin ist aus JP 2001-083187 und JP 2001-121675 ein faseroptischer Stromsensor und ein entsprechender Sensorkopf bekannt, der es ermöglicht, eine Sensorspulenschlaufe um einen Stromleiter anzuordnen, ohne den Stromleiter zu unterbrechen. Dazu ist eine Sensorfaser des Sensors an ihren beiden Enden an je einem starren halbkreisförmigen Rahmenstück befestigt, welche beiden Rahmenstücke durch ein Scharnier miteinander verbunden sind und in einem geschlossenen Zustand einen Ring bilden, auf dessen äusserer Seite die Sensorfaser verläuft. Messungen mit einer Genauigkeit im Promill-Bereich sind mit einem solchen Sensor nicht möglich, und ein Transport und eine Montage des Sensorkopfes unter beengten Platzverhältnissen ist erschwert.

In der JP-A-09 068 618 ist ein faseroptischer Sensor offenbart, dessen Sensorfaser exentrisch nach aussen verschoben in einem Coating eingebettet ist, um Faserdeformation und Microbending gering zu halten.

**Darstellung der Erfindung**

Es ist Aufgabe der Erfindung, einen Sensorkopf und einen Strom- oder Magentfeldsensor der eingangs genannten Art zu schaffen, welche die oben genannten Nachteile nicht aufweisen. Insbesondere soll eine weitgehend temperaturunabhängige und genaue Strom- oder Magnetfeldmessung mit einem gut montierbaren Sensorkopf ermöglicht werden, wobei Messungen mit grossen Sensorspulendurchmessern ermöglicht werden sollen, wie es beispielsweise zur Messung von Strömen in Stromleitern mit grossem Querschnitt erforderlich ist.

Insbesondere soll die hohe Messgenauigkeit auch erreicht werden, wenn die Sensorspule wiederholt montiert und abmontiert wird, und ohne dass dadurch eine erneute Kalibration des Sensors erforderlich wäre. Es soll ermöglicht werden, den Sensor bei der Herstellung (der Sensorspule oder des Sensors) zu kalibrieren, dann die Sensorfaser in eine andere Form zu bringen, und dann am Einsatzort unter erneuter Bildung einer Spule zu montieren, ohne dass eine erneute Kalibration des Sensors erforderlich wäre. Die Montage des Sensors und der Sensorspule um einen Stromleiter soll ohne ein Öffnen des Stromleiters erfolgen können. Diese Aufgaben löst ein faseroptischer Sensorkopf mit den Merkmalen des unabhängigen Patentanspruchs 1 sowie ein Verfahren zur Herstellung eines Sensorkopfes mit den Merkmalen des unabhängigen Patentanspruchs 19. Ein erfindungsgemässer faseroptischer Sensorkopf für einen Strom- oder Magnetfeldsensor umfasst eine optische Faser, welche eine magnetooptisch aktive Sensorfaser in optischer Verbindung mit mindestens einem polarisationsdefinierenden Element beinhaltet, wobei die Sensorfaser um einen den zu messenden Strom führenden Leiter oder in einem zu messenden Magnetfeld in Form einer Spule anordnbar ist, wobei durch die Spule eine Spulenebene mit einer Flächennormalen definiert ist, und wobei das mindestens eine polarisationsdefinierende Element eine ausgezeichnete Achse aufweist.

Der Sensorkopf ist weiterhin im Bereich der Sensorfaser biegbar (flexibel), und ein Einstellmittel zur Einstellung eines vorgebbaren Winkels $\beta$ zwischen der ausgezeichneten Achse und der Flächennormalen oder zur Einstellung von vorgebbaren Winkeln $\beta,\beta'$ zwischen den ausgezeichneten Achsen und der Flächennormalen ist vorhanden. Im Falle von zwei polarisationsdefinierenden Elementen liegt der Winkel $\beta$ zwischen einer ausgezeichneten Achse des einen polarisationsdefinierenden Elementes und der Flächennormalen vor, und der Winkel $\beta'$ liegt zwischen einer ausgezeich-

neten Achse des anderen polarisationsdefinierenden Elementes und der Flächennormalen vor.

Die Sensorfaser ist eine nicht bei mindestens der Erweichungstemperatur des Sensorfasermaterials thermisch behandelte Faser. Dadurch verbleibt die Sensorfaser in einem besonders biegsamen Zustand, wodurch die Herstellung von Sensorköpfen für Spulen grossen Durchmessers und die Montage des Sensorkopfes deutlich vereinfacht ist.

Die Sensorfaser ist von ihrer Faserschutzhülle befreit. Dass die Sensorfaser von ihrer Faserschutzhülle befreit ist, vermeidet die Induzierung unerwünschter Doppelbrechung durch mechanische Kräfte, die bei Temperaturveränderungen im allgemeinen auftreten und die die Faserschutzhülle auf die Faser ausübt. Denn im allgemeinen sind die thermischen Ausdehnungskoeffizienten von Faserschutzhülle und Cladding verschieden gross. Solche störende Doppelbrechungen führen typischerweise zu Messungenauigkeiten von 1 % bis 2 % und mehr.

Der Begriff Spule bedeutet hier nicht, dass die Spule notwendigerweise eine oder mehrer geschlossene Windungen haben muss oder dass sie notwendigerweise runde oder spiralförmig angeordnete Windungen haben muss. Im Falle eines Stromsensors sind diese Merkmale zwar von Vorteil. Im Falle eines Magnetfeldsensors hingegen darf die Spule nicht geschlossen sein; vielmehr ist die Sensorfaser mit Vorteil eher länglich entlang des Magnetfeldes erstreckt. Auch in einem solchen Falle gilt hier die Sensorfaser als zu einer Spule angeordnet. Wenn beispielsweise die Faser in Form eines Kreissegmentes angeordnet ist, ist die Spulenebene als die Ebene gegeben, welche dieses Kreissegment enthält. In dem Fall, dass die Sensorfaser perfekt linear (ungekrümmt) angeordnet ist, bildet sie keine Spule, und es ist auch keine Spulenebene definiert.

Erfinderische Überlegungen haben ergeben, dass der Winkel $\beta$ oder die Winkel $\beta,\beta'$, durch den oder durch die die azimutale Orientierung des polarisationsdefinierenden Elementes gegenüber der Spulenebene gegeben ist, einen kleinen Einfluss auf die Kalibration haben kann. Dieser liegt typischerweise im Promill-Bereich, kann aber auch bis in den Prozentbereich gehen. Für hochgenaue Messungen muss daher der Winkel $\beta$ beziehungsweise müssen die Winkel $\beta,\beta'$ berücksichtigt werden. Die erfinderischen Überlegungen, die zu der Erkenntnis der Relevanz des Winkel $\beta$ oder der Winkel $\beta,\beta'$ geführt haben, sind weiter unten dargelegt.

Ein erfindungsgemässer Sensor liefert im allgemeinen ein Mess-Signal, das einer messgrössenabhängigen Phasenverschiebung proportional ist. Die Kalibration bedeutet im wesentlichen, dass ein konstanter Faktor (Kalibrationsfaktor) gesucht und eingestellt wird, so dass ein vorgebbarer Strom (beispielsweise 1 kA) oder ein vorgebbares Magnetfeld einen gewünschtes Ausgangssignal (beispielsweise 1 Skalenteil oder 1 V) gibt. Tritt vor oder bei der Montage des Sensorkopfes eine Veränderung des Kalibrationsfaktors auf, so ist die Messgenauigkeit des Sensors beeinträchtigt, und eine erneute Kalibration ist angezeigt.

Ein erfinderischer Sensorkopf ist im allgemeinen entweder für einen Sensor in einer Reflex-Konfiguration oder einen Sensor in einer Sagnac-Konfiguration vorgesehen. In ersterem Falle ist an einem Ende der Sensorfaser eine Verspiegelung vorgesehen, während das andere Ende mit einem Polarisator oder mit einem Phasenverzögerungselement oder einer polarisationserhaltenden Zuleitungsfaser versehen ist. Der Polarisator beziehungsweise das Phasenverzögerungselement oder die Zuleitungsfaser definieren den Polarisationszustand des Lichtes, das in die Sensorfaser eintritt. Sie dienen somit als polarisationsdefinierende Elemente. Es ergibt sich ein Winkel $\beta$ zwischen der Flächennormale der Spulenebene und der ausgezeichneten Achse des polarisationsdefinierenden Elementes (beim Polarisator: die Achse entlang der Transmissionsrichtung; beim Phasenverzögerungselement oder einer polarisationserhaltenden Zuleitungsfaser: eine der Hauptachsen, beispielsweise die langsame Hauptachse).

Im Falle einer polarisationserhaltenden Zuleitungsfaser oder eines faseroptischen Polarisators sind die Achsenrichtungen beziehungsweise die Durchlassrichtung unmittelbar vor dem Phasenverzögerungselement beziehungsweise vor der Sensorfaser massgeblich, denn die Zuleitungsfaser oder ein Faserpolarisator könnte tordiert sein, so dass die Achsenrichtungen entlang der Faser variieren.

In der Sagnac-Konfiguration sind beide Enden der Sensorfaser mit je einem solchen polarisationsdefinierenden Element versehen, so dass sich zwei Winkel $\beta,\beta'$ ergeben, die durchaus verschieden gross gewählt sein können. Im Falle eines Sensors in Sagnac-Konfiguration ist bei der Montage ein Spleiss- oder ein Steck-Vorgang vorzunehmen, wenn der Sensorkopf montiert werden soll, ohne den Leiter zu öffnen.

Mit Vorteil dient als Einstellmittel eine mechanische Vorrichtung zur Fixierung des Winkels $\beta$ oder der zwei Winkel $\beta,\beta'$.

Mit grossem Vorteil ist die Sensorfaser in einer Kapillare angeordnet. Die Kapillare übernimmt den mechanischen Schutz der von der Faserschutzhülle befreiten Faser und verhindert das Einwirken äusserer Kräfte auf die Faser.

Vorteilhaft ist das Einstellmittel vorgesehen, um (indem durch das Einstellmittel der Winkel $\beta$ reproduzierbar einstellbar ist oder die Winkel $\beta,\beta'$ reproduzierbar einstellbar sind) eine Reproduzierbarkeit einer Gesamt-Doppelbrechung der Sensorfaser zu erreichen, wenn die Sensorfaser zwischen einer Kalibration des Strom- oder Magnetfeldsensors und einer Montage der Spule an einem Einsatzort in eine andere Form gebracht wird.

In der Praxis setzt sich diese Gesamt-Doppelbrechung im wesentlichen aus den folgenden Beiträgen zusammen:

- Biegungs-induzierte Doppelbrechung,

- Intrinsische Doppelbrechung durch internen Stress in der Sensorfaser und durch eine nicht-perfekt rotationssymmetrische Form des Faserkerns der Sensorfaser,
- Stress an Faserspleissen des Sensorkopfes, und
- Doppelbrechung dadurch, dass die Sensorfaser in entspanntem Zustand nicht genau linear ist, sondern eine Vorkrümmung aufweist.

Das Auftreten dieser Doppelbrechungsbeiträge, die ein Mess-Signal im Promill- oder Prozentbereich beeinflussen, ist kaum vermeidbar, aber ihr gemeinsamer Einfluss auf ein Mess-Signal kann bei einem erfindungsgemässen Sensor reproduziert werden, mit den bereits genannten Vorteilen.

In einer vorteilhaften Ausführungsform beinhaltet das Einstellmittel einen Trägerkörper, an dem das mindestens eine polarisationsdefinierende Element fixiert ist.

Vorteilhaft ist der Trägerkörper ein flexibel verformbarer Trägerkörper. Dieser hat den Vorteil, dass seine Form (und somit die Form des Sensorkopfes) an äussere Gegebenheiten (vorhandener Platz, vorgegebene Geometrie am Einsatzort) anpassbar ist, eine vereinfachte Montage erlaubt und einfach und platzsparend transportierbar ist.

Mit Vorteil ist der Trägerkörper derart ausgebildet, dass durch ihn und die Fixierung des polarisationsdefinierenden Elementes der mindestens eine Winkel β festgelegt ist.

Besonders vorteilhaft ist der Trägerkörper derart ausgebildet, dass durch ihn und die Fixierung des polarisationsdefinierenden Elementes an ihm die relative Lage der ausgezeichneten Achse oder Achsen bezüglich der Spulenebene festgelegt ist. Mit Vorteil kann der Trägerkörper die Form der Spule vorgeben.

In einer besonders vorteilhaften Ausführungsform ist die Sensorfaser entlang einer Längsachse des Trägerkörpers erstreckt. Dadurch wird die Form der Spule durch die Form des Trägerkörpers vorgegeben. Mit Vorteil ist eine bevorzugte Biegerichtung des Trägerkörpers senkrecht zu der Längsachse vorgegeben. Dadurch kann bei einem flexiblen Trägerkörper vorgegeben werden, in welcher Weise dieser in einer spulenförmigen Art geformt werden kann. Der Trägerkörper ist deshalb mit Vorteil flexibel (zumindest für eine ausgezeichnete Biegerichtung). Die Form der Spule kann dann auch an die Form eines Gehäuses angepasst werden.

In einer bevorzugten Ausführungsform ist die Sensorfaser bei Biegung des Trägerkörpers in die bevorzugte Biegerichtung in oder nahe der neutralen Ebene des Trägerkörpers angeordnet. Dadurch wird mechanischer Stress minimiert, den die Sensorfaser bei der Formung der Spule durch Biegung des Trägerkörpers erfährt. Dies führt zu einer grösseren Messgenauigkeit und Kalibrationsstabilität eines Sensors, der mittels des Sensorkopfes misst.

Besonders vorteilhaft ist der Winkel β oder die Winkel β,β' in Abhängigkeit

- von intrinsischer Doppelbrechung der Sensorfaser und Doppelbrechung an Spleissen,
- von biegungs-induzierter Doppelbrechung, und
- von Doppelbrechung aufgrund einer Vorkrümmung der Sensorfaser derart gewählt ist, dass
- der Einfluss von Änderungen der biegungs-induzierten Doppelbrechung oder
- der Einfluss von Änderungen des Winkels β beziehungsweise der Winkel β,β'

auf Mess-Signale, die von einem Strom- oder Magnetfeldsensor mit dem Sensorkopf (2) erzeugbar sind, minimal ist.

Es wurde herausgefunden, dass eine solche Wahl von entsprechenden konkreten Winkeln β möglich ist. Die genannten Doppelbrechungen sind bestimmbar; und beispielsweise mittels Jones-Matrizen ist ein entsprechendes Mess-Signal, beispielsweise ein normiertes Signal, in Abhängigkeit von dem Winkel β berechenbar. Daraus ergeben sich die gesuchten Winkel β. Das Mess-Signal ergibt sich aus der Phasenverschiebung, die das sich in dem Sensorkopf während einer Messung ausbreitende Licht erfährt, und ist im wesentlichen proportional zu dem zu messenden Strom oder Magnetfeld.

In einem bevorzugten Aufbau ist die Sensorfaser im wesentlichen in der Spulenebene angeordnet. Dabei ist (im Falle eines reflektiven interferometrischen Sensors) das polarisationsdefinierende Element eine polarisationserhaltende Zuleitungsfaser, wobei zwischen der polarisationserhaltenden Zuleitungsfaser und der Sensorfaser ein Phasenverzögerungselement angeordnet ist, welches einen Phasenverzögerungswinkel aufweist, der von dem Phasenverzögerungswinkel eines idealen Phasenverzögerungselementes um einen von null verschiedenen Winkel ε abweicht, und wobei der Winkel β als $β = 0° \pm n \times 90°$ oder als $β = 45° \pm n \times 90°$ gewählt ist, wobei n eine positive ganze Zahl oder null ist; oder (im Falle eines interferometrischen Sensors in Sagnac-Konfiguration) sind die polarisationsdefinierenden Elemente zwei Zuleitungsfasern, wobei zwischen den Zuleitungsfasern und der Sensorfaser jeweils ein Phasenverzögerungselement angeordnet ist, und wobei mindestens eines der beiden Phasenverzögerungselemente einen Phasenverzögerungswinkel aufweist, der von dem Phasenverzögerungswinkel eines idealen Phasenverzögerungselementes um einen von null verschiedenen Winkel ε abweicht, und wobei die Winkel β,β' ist als $β = β' = 0° \pm n \times 90°$ oder als $β = β' = 45° \pm n \times 90°$ gewählt sind, wobei n eine positive ganze Zahl oder null ist.

Der von null verschiedene Winkel ε wird typischerweise gewählt, um eine intrinsische Temperatur-Kompensation des Sensors zu erreichen. Im Falle der Sagnac-Konfiguration sind die Zuleitungsfasern vorteilhaft polarisationserhaltende Fasern; sie können aber auch von einem anderen Fasertyp sein, beispielsweise single-mode, und dann noch jeweils einen Polarisator umfassen, durch welchen die ausgezeichnete Richtung des polarisationsdefinierenden Elementes definiert wird.

Durch der Wahl des Winkels $\beta$ oder der Winkel $\beta,\beta'$ als 0° ± n×90° kann der Einfluss, den Änderungen der Spulenform auf die Sensorgenauigkeit und die Kalibration haben, minimiert werden, da der Einfluss von Änderungen der biegungs-induzierten Doppelbrechung einen minimalen Einfluss auf ein Mess-Signal haben.

Durch der Wahl des Winkels $\beta$ oder der Winkel $\beta,\beta'$ als 45° ± nx90° kann der Einfluss von Änderungen der Winkel $\beta,\beta'$ auf Mess-Signale minimiert werden. Auch durch andere Kombinationen der Winkel $\beta$ und $\beta'$, bei denen $\beta$ und $\beta'$ voneinander verschieden sind, ist diese Minimierung erreichbar.

Die Vorteile durch die Wahl des Winkels $\beta$ oder der Winkel $\beta,\beta'$ als als 0° ± nx90° oder als 45° ± n×90° ergeben sich, solange die intrinsische Doppelbrechung nicht grösser als die biege-induzierte Doppelbrechung ist.

Eine sehr vorteilhafte Ausführungsform ist dadurch gekennzeichnet, dass Markierungen vorhanden sind, die derart an dem Einstellmittel angebracht sind, dass die Spule eine ganze Anzahl von Windungen aufweist, wenn die Markierungen in geeigneter Weise zueinander angeordnet sind. Dadurch ist auf einfache Weise eine genaue und weitgehend störungsunempfindliche Strommessung möglich. Die beiden Enden der Sensorfaser können sehr nahe beieinander angeordnet werden. Einerseits ist eine Strommessung bei einer ganzzahligen Anzahl von Spulenwindungen sehr unempflindlich gegenüber der Stromleiterposition innerhalb der Spule, und andererseits ist der Einfluss von Strömen, die durch einen nicht durch die Spule geführten Leiter fliessen, und der Einfluss von anderen Störfeldern vernachlässigbar klein. Dies ist beispielsweise dann besonders wichtig, wenn an einem oder mehreren von mehreren benachbarten Stromleiten der Strom gemessen werden soll.

Solche Markierungen sind mit Vorteil in unmittelbarer Nähe der beiden Enden der Sensorfaser oder nahe der beiden Enden der Sensorfaser oder zumindest im Abstand der Länge der Sensorfaser angebracht. Beispielsweise können Bohrungen als derartige Markierungen dienen.

Derartige Markierungen sind auch an einem solchen Einstellmittel vorsehbar, das nicht ein Einstellmittel zur Einstellung eines vorgebbaren Winkels $\beta$ zwischen der ausgezeichneten Achse und der Flächennormalen oder zur Einstellung von vorgebbaren Winkeln $\beta,\beta'$ zwischen den ausgezeichneten Achsen und der Flächennormalen ist. Dann ist das Einstellmittel ein Einstellmittel zur Einstellung einer ganzzahligen Anzahl von Windungen.

Mit Vorteil bestehen die Kapillare und/oder die Sensorfaser im wesentlichen aus Quarzglas.

Ein erfindungsgemässer Strom- oder Magnetfeldsensor beinhaltet einen erfindungsgemässen Sensorkopf und weist die entsprechenden Vorteile auf. Ein solcher Sensor kann mit Vorteil sein:

a) ein interferometrischer Sensor in Reflexionskonfiguration mit einer polarisationserhaltenden Zuleitungsfaser als dem einen polarisationsdefinierenden Element, wobei die eine ausgezeichnete Achse die schnelle oder die langsame Hauptachse der Zuleitungsfaser ist, oder

b) ein interferometrischer Sensor in Sagnac-Konfiguration mit zwei polarisationserhaltenden Zuleitungsfasern als polarisationsdefinierenden Elementen, wobei die zwei ausgezeichneten Achsen die schnellen oder die langsamen Hauptachsen (oder je eine schnelle und eine langsame Hauptachse) der zwei Zuleitungsfasern sind, oder

c) ein polarimetrischer Sensor in Reflexionskonfiguration mit einem Polarisator als polarisationsdefinierendem Element oder mit einer polarisationserhaltenden Zuleitungsfaser als polarisationsdefinierendem Element, wobei die eine ausgezeichnete Achse entlang der Transmissionsrichtung des Polarisators beziehungsweise entlang einer Hauptachse der polarisationserhaltenden Zuleitungsfaser verläuft, oder

d) ein polarimetrischer Sensor in Sagnac-Konfiguration mit zwei Polarisatoren als polarisationsdefinierenden Elementen oder mit zwei polarisationserhaltenden Zuleitungsfasern als polarisationsdefinierenden Elementen, und wobei die zwei ausgezeichneten Achsen entlang der Transmissionsrichtungen der zwei Polarisatoren beziehungsweise entlang der Hauptachsen der polarisationserhaltenden Zuleitungsfasern verlaufen.

In den Fällen a) und b) kann auch ein mit der Sensorfaser optisch verbundenes Phasenverzögerungselement oder können auch zwei mit je einem Ende der Sensorfaser optisch verbundene Phasenverzögerungselemente als das polarisationsdefinierende Element oder als die polarisationsdefinierenden Elemente dienen.

Im Fall b) kann mindestens eine der zwei polarisationserhaltenden Zuleitungsfasern durch eine andersartige Faser, beispielsweise eine Single-Mode Faser, und einen Polarisator ersetzt werden. Die Durchlassrichtung des Polarisators gibt dann die ausgezeichnete Richtung an.

Eine erfindungsgemässe Hochspannungsanlage weist mindestens einen erfindungsgemässen Sensorkopf oder einen erfindungsgemässen Stromsensor auf. Beispielsweise kann die Hochspannungsanlage eine vorteilhaft dreipolige Hochspannungsschaltanlage sein, zum Beispiel gasisoliert oder luftisoliert.

Das erfindungsgemässe Verfahren zur Herstellung eines Sensorkopfes für einen optischen Strom- oder Magnetfeldsensor bei dem eine magnetooptisch aktive Sensorfaser, die in optischer Verbindung mit mindestens einem polarisationsdefinierenden Element steht, in Form einer Spule angeordnet wird, wobei als Sensorfaser eine nicht bei mindestens der Erweichungstemperatur des Sensorfasermaterials thermisch behandelte Faser verwendet wird, wobei durch die Spule eine Spulenebene mit einer Flächennormalen definiert ist, wobei das polarisationsdefinierende Element eine ausgezeichnete Achse aufweist, wobei eine Kalibrierung des mit der spulenförmig angeordneten Sensorfaser versehenen Strom- oder Magnetfeldsensor vorgenommen wird, und wobei der Sensorkopf mit einem Einstellmittel versehen wird, durch welches bei einem erneuten Anordnen der Sensorfaser zu einer Spule der Winkel $\beta$ zwischen der ausgezeichneten Achse des polarisationsdefinierenden Elementes und der Flächennormalen gleich gross einstellbar ist wie während der Kalibrierung, ist dadurch gekennzeichnet, dass eine von ihrer Faserschutzhülle befreite Sensorfaser verwendet wird, die Sensorfaser in einer Kapillare gelagert wird, die Kapillare ein Reibungsverminderungsmittel enthält, das Einstellmittel einen Trägerkörper beinhaltet, an dem das mindestens eine polarisationsdefinierende Element fixiert ist und der Trägerkörper ein flexibel verformbarer Trägerkörper ist.

Ein derart hergestellter Sensorkopf hat den Vorteil, dass mit ihn sehr genaue Messungen durchführbar sind, ohne dass nach einem Verformen der Sensorspule ein erneutes Kalibrieren nötig wäre. Ein solcher Sensorkopf ist vorkalibriert. Seine Montage am Einsatzort ist vereinfacht.

Weitere bevorzugte Ausführungsformen und Vorteile gehen aus den abhängigen Patentansprüchen und den Figuren hervor.

## Kurze Beschreibung der Zeichnungen

Im folgenden wird der Erfindungsgegenstand anhand von bevorzugten Ausführungsbeispielen, welche in den beiliegenden Zeichnungen dargestellt sind, näher erläutert. Es zeigen:

Fig. 1     einen erfindungsgemässen Sensorkopf, schematisch;
Fig. 2     die Definition des Winkels $\beta$ bei einer Faser mit elliptischem Kernquerschnitt;
Fig. 3     eine Darstellung einer berechneten Abhängigkeit eines normierten Signales vom Winkel $\beta$;
Fig. 4     eine Darstellung einer berechneten Abhängigkeit eines normierten Signales vom Winkel $\beta$ und entsprechende experimentell bestimmte Werte;
Fig. 5     einen Schnitt durch einen erfindungsgemässen Sensorkopf im Bereich der Sensorfaser, schematisch;
Fig. 6     Aufbau eines interferometrischen Sensors in Sagnac-Konfiguration, schematisch;
Fig. 7     Aufbau eines reflektiven interferometrischen Sensors, schematisch.

Die in den Zeichnungen verwendeten Bezugszeichen und deren Bedeutung sind in der Bezugszeichenliste zusammengefasst aufgelistet. Grundsätzlich sind in den Figuren gleiche oder gleichwirkende Teile mit gleichen Bezugszeichen versehen. Die beschriebenen Ausführungsbeispiele stehen beispielhaft für den Erfindungsgegenstand und haben keine beschränkende Wirkung.

Wege zur Ausführung der Erfindung

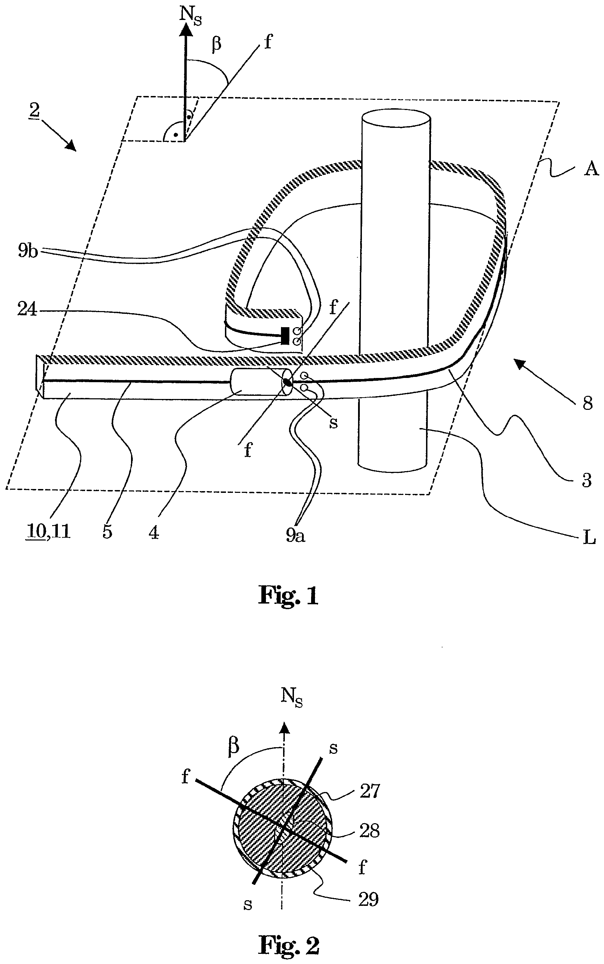

Fig. 1 zeigt schmeatisch einen erfindungsgemässen Sensorkopf 2 in Reflex-Konfiguration. Eine polarisationserhaltende Zuleitungsfaser 5 dient der Verbindung des Sensorkopfes 2 mit einem nicht-dargestellten optoelektronischen Modul. Durch die Zuleitungsfaser 5 eingekoppeltes Licht gelangt zunächst in ein vergrössert dargestelltes faseroptische

Phasenverzögerungselement 4, das der Erzeugung zirkularer oder elliptischer Polarisation dient. Das Phasenverzögerungselement 4 ist an einem Ende einer Sensorfaser 3 vorgesehen, welche in Form einer Spule 8 mit einer Windung um einen Leiter L angeordnet ist. Das andere Ende der Sensorfaser 3 ist verspiegelt oder mit einem Spiegel 24 versehen. Die Sensorfaser 3 hat vorteilhaft eine nominal sehr geringe Doppelbrechung. Sie hat eine Verdet-Konstante, so dass durch den Faraday-Effekt eine nichtreziproke Phasenverschiebung von sich in der Sensorfaser 3 ausbreitenden Lichtwellen erzielbar ist.

Die optischen Fasern 3,4,5 sind an einem als Einstellmittel 10 dienenden Trägerkörper 11 fixiert. Als Trägerkörper 11 dient ein Streifen aus glasfaserverstärktem Kunststoff.

Durch die Spule 8, die vorteilhaft eine ganze Anzahl von Windungen aufweist, ist eine Spulenebene A definiert, welche eine Flächennormale $N_S$ hat. Die Spule 8 kann auch mehrere Windungen aufweisen. Insbesondere kann sie mehrere Windungen (auch eine nicht-ganzzahlige Anzahl) in spiralartiger oder schraubenwindungsartiger Form aufweisen. Eine Spulenebene A ist stets definierbar.

Das Phasenverzögerungselement 4, welches hier als ein polarisationsdefinierendes Element 4 fungiert, weist eine schnelle Hauptachse f und eine langsame Hauptachse s als zwei ausgezeichnete Achsen auf. Der von der Flächennormalen $N_S$ und der schnellen Achse f gebildete Winkel ist hier als Winkel $\beta$ bezeichnet.

Das Phasenverzögerungselement 4 ist an dem Kunststoffstreifen 11 befestigt, so dass seine Position und Winkelorientierung bezüglich des entsprechenden Bereiches des Kunststoffstreifens 11 fix ist. Durch die Geometrie des Querschnittes des Trägerkörpers 11 ist die Radialrichtung, entlang der sich der Kunststoffstreifen 11 bevorzugt (weil mit relativ geringem Kraftaufwand) biegen lässt, vorgegeben, so dass die relative Lage der Spulenebene A zu der schnellen Achse f vorgegeben ist. Dadurch ist der Winkel β vorgegeben. Es ist auch denkbar, den Trägerkörper aus nichtisotropen Materialien oder aus Materialkombinatinationen zu fertigen, so dass eher durch das Material als durch die Querschnitts-Geometrie die bevorzugte Biegerichtung gegeben ist.

Zusätzlich sind an dem Trägerkörper noch zwei Markierungen 9a,9b in Form von je zwei Bohrungen vorgesehen. Mittels dieser Bohrungen 9a,9b können in definierter Weise die beiden Enden der Sensorfaser in unmittelbarer Nähe voneinander angeordnet werden, so dass eine fast perfekt geschlossene Spule 8 mit einer ganzen Anzahl von Windungen entsteht. In Fig. 1 sind zum Zwecke einer klareren Darstellung die beiden Sensorfaserenden voneinander beabstandet dargestellt.

Bei der Herstellung des Sensorkopfes 2 kann ein aus dem Sensorkopf 2 und einem optoelektronischen Modul bestehender Sensor kalibriert werden, wobei ein Winkel β vorgebbar ist. Dann kann der Sensorkopf 2 andersartig angeordnet werden, beispielsweise zu Transportzwecken enger aufgerollt werden, und an einem Einsatzort des Sensors in gleicher oder anderer Weise angeordnet werden wie während der Kalibration. Der Winkel β allerdings wird durch das Einstellmittel 10 wieder genauso gross gewählt werden können wie während der Kalibration, so dass keine erneute Kalibration des Sensors am Einsatzort notwendig ist, um eine grosse Messgenauigkeit zu erreichen. Insofern wird durch das Einstellmittel 10 ein reproduzierbares Einstellen des Winkels β ermöglicht.

Fig. 2 zeigt schematisch die Definition des Winkels β bei einer Faser mit elliptischem Kernquerschnitt. Diese Faser kann eine Zuleitungsfaser 5 oder ein faseroptisches Phasenverzögerungselement 4 sein. Um den Faserkern 28, der die Lage der Hauptachsen s,f definiert, ist der Fasermantel 27 angeordnet. Die Faser weist noch eine Faserschutzhülle 29 auf, welche den Fasermantel 27 umgibt.

Im Falle der Sensorfaser 3 ist eine solche Faserschutzhülle 29 mit Vorteil nicht vorhanden.

Der Vorteil einer Fixierung der azimutalen Orientierung des polarisationsdefinierenden Elementes 4 zu der Spulenebene A ergibt sich aus folgenden Überlegungen:

Im Falle eines reflektiven interferometrischen Sensors beträgt die durch einen zu messenden Strom 1 in der Sensorfaser 3 induzierten Phasenverschiebung $\Delta\phi_R$ zwischen sich in der Sensorfaser 3 ausbreitenden links- und rechts-zirkularpolarisierten Lichtwellen:

$$\Delta\phi_R = 4\varphi_F = 4VNI$$

Dabei ist $\varphi_F$ die Faraday-Phasenverschiebung $V \cdot N \cdot I$ mit V Verdet-Konstante der Sensorfaser, N Anzahl Windungen der Spule und I Strom. In diesem Fall wird ein λ/4-Element als Phasenverzögerungselement 4 angenommen, wobei die Hauptachsen der Doppelbrechung des Phasenverzögerungselementes 4 einen Winkel von 45° mit den Hauptachsen der Doppelbrechung der Zuleitungsfaser 5 bilden. Die obige Gleichung gilt nur dann genau, wenn die Sensorfaser 3 keinerlei Doppelbrechung aufweist. Aber auch im Falle von nominal sehr niedrig-doppelbrechenden Fasern 3, liegt eine geringe Doppelbrechung vor.

In der Praxis tragen die folgenden Beiträge zu der nicht-verschwindenden Doppelbrechung bei:

(1) Biegungs-induzierte Doppelbrechung
(2) Intrinsische Doppelbrechung durch internen Stress in der Faser und durch eine nicht-perfekt rotationssymmetrische Form des Faserkerns der Sensorfaser 3
(3) Stress an Faserspleissen, beispielsweise zwischen dem λ/4-Element 4 und der Sensorfaser 3.
(4) Doppelbrechung dadurch, dass die Sensorfaser 3 im entspannten Zustand nicht genau linear ist, sondern eine Vorkrümmung aufweist, wodurch eine Rotation der spulenförmig angeordneten Faser 3 um die eigene Achse zu Doppelbrechungsveränderungen führt.

Bei einer Veränderung des Winkels β verändern sich die Achsen für die Beiträge (2) und (3) um denselben Winkel. Aber die Hauptachsen der Doppelbrechung für den Beitrag (1) bleiben stets parallel beziehungsweise senkrecht zu der Biegerichtung. Darum verändert sich die Gesamt-Doppelbrechung, wenn der Winkel β, also die azimutale Orientierung der Faser 3a, geändert wird.

Der Beitrag (4) ist meist kleiner als die anderen Beiträge oder auch null. Dass dieser Beitrag (4) ebenfalls abhängig ist vom Winkel β, ergibt sich aus seiner Natur.

Unter Berücksichtigung der vorhandenen Doppelbrechung ergibt sich aus einer Beschreibung der Lichtausbreitung mit Hilfe von Jones-Matrizen als genauerer Wert für die durch einen zu messenden Strom I in der Sensorfaser 3 induzierten Phasenverschiebung $\Delta\phi_R$ zwischen sich in der Sensorfaser 3 ausbreitenden links- und rechts-zirkularpolarisierten Lichtwellen (reflektiver interferometrischer Sensor):

$$\Delta\phi_R = 4\varphi_F \cdot (1 + (1/3) \cdot \delta^2)$$

Dabei ist $\delta$ die gesamte doppelbrechende Phasenverschiebung in der Sensorfaser 3. Unter Berücksichtigung der individuellen Terme und $\beta$-Abhängigkeiten der Beiträge (1) bis (4) ergibt sich

$$\Delta\phi_R = 4\varphi_F \{1 + (1/3) [\delta_b^2 + \delta_0^2 + (1/2) \delta_1^2] + (2/3) [\delta_b\delta_0 + (1/4) \delta_1^2] \cos(2\beta) +$$

$$(1/3) [(\delta_b + 2\delta_0) \cos\beta + \delta_b \cos(3\beta)] \delta_1\}$$

mit folgenden Abkürzungen:

$\delta_b$: doppelbrechende Phasenverschiebung aufgrund von Beitrag (1), also biege-induziert;
$\delta_0$: doppelbrechende Phasenverschiebung aufgrund von Beiträgen (2) und (3), also durch intrinsische Doppelbrechung und Doppelbrechung an Spleissen;
$\delta_1$: doppelbrechende Phasenverschiebung aufgrund von Beitrag (4).

Analoge Überlegungen gelten für den Fall der Sagnac-Konfiguration und für den Fall polarimetrischer Sensoren.

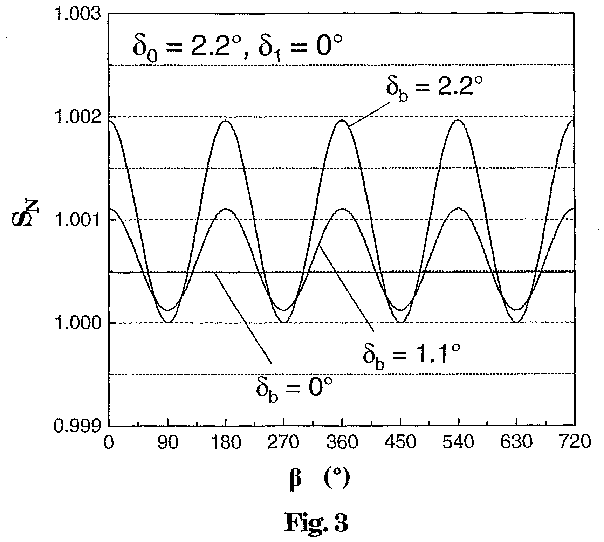

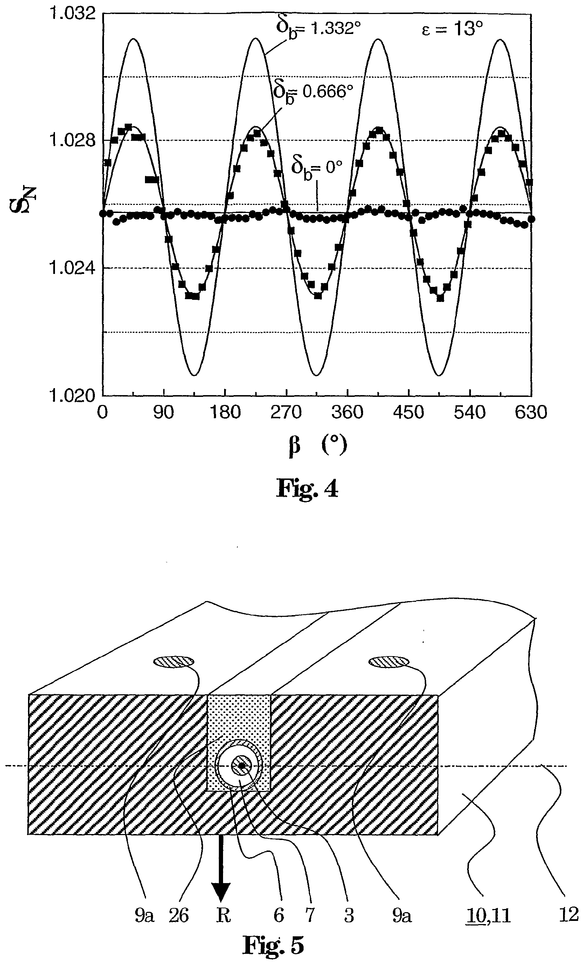

Fig. 3 zeigt eine Darstellung einer berechneten Abhängigkeit eines normierten Signales $S_N$ vom Winkel $\beta$, wieder für einen reflektiven interferometrischen Sensor. Die polarisationserhaltende Zuleitungsfaser 5, welches hier als das polarisationsdefinierende Element 5 betrachtet wird, weist eine schnelle und eine langsame Hauptachse als zwei ausgezeichnete Achsen auf. Der von der Flächennormalen Ns und der schnellen Achse gebildete Winkel ist hier für die Berechnungen der Figs. 3 und 4 als der Winkel $\beta$ bezeichnet. Für diese Berechnungen wurde weiterhin angenommen, dass die Sensorfaser im wesentlichen in der Spulenebene angeordnet ist.
Das normierte Signal ist definiert als

$$S_N = \Delta\phi_R/4\varphi_F.$$

Für $\delta_0 = 2.2°$, und $\delta_1 = 0°$ und die Werte 0°, 1.1° und 2.2° für $\delta_b$ ist $S_N$ in Fig. 3 dargestellt. $S_N$ variiert im Bereich bis $\pm 1$ oder $\pm 2$ Promill. Der Wert $\delta_b = 1.1°$ entspricht der biegeinduzierten Doppelbrechung im Falle einer ursprünglich linear erstreckten Quarzfaser, die zu einer Spule mit einer Windung und einem Spulendurchmesser von 1 m bei einem Faserdurchmesser von 80 $\mu$m gewunden ist. Es wurde bei der Berechnung von Fig. 3 angenommen, dass das Phasenverzögerungselement 4 ein perfektes $\lambda/4$-Element ist, also genau 90° Phasenverzögerung erzeugt. Zum Erreichen einer intrinsischen Temperaturkompensation kann ein Phasenverzögerungselement 4 eingesetzt werden, das einen davon abweichenden Phasenverzögerungswinkel 90°$+\varepsilon$ erzeugt. Näheres zu der Temperaturkompensation kann der europäischen Patentanmeldung EP 1115000 oder der internationalen Offenlegungsschrift WO 03/071290 A1 entnommen werden. Im Falle einer solchen Temperatur-Kompensation kann vorteilhaft auch der Winkel zwischen den Hauptachsen der Zuleitungsfaser und des Phasenverzögerungselementes von 45° abweichend gewählt sein.
Unter Berücksichtigung eines nicht-verschwindenden Winkels $\varepsilon$ ergeben sich im Falle von $\delta_0 = 0°$, und $\delta_1 = 0°$ und für die Werte 0°, 0.666° und 1.332° für $\delta_b$, also für den Fall, dass ausschliesslich biege-induzierte Doppelbrechung vorliegt, die in Fig. 4 dargestellten Werte für das normierte Signal $S_N$ in Abhängigkeit vom Winkel $\beta$. Die durchgezogenen Linien sind berechnete Werte, die Kreise und Quadrate sind experimentell bestimmte Werte. Es wurde der Fall $\varepsilon = 13°$ betrachtet. Im Falle von $\delta_b = 0.666°$ wurde eine Faser mit 80 $\mu$m Durchmesser bei einem Spulenradius von 0.821 m untersucht. Wie Fig. 4 zu entnehmen ist, können Schwankungen von mehreren Prozent die Folge einer Nicht-Berücksichtigung des Winkels $\beta$ sein.
Die folgenden Gleichungen, die ebenfalls mittels der Jones-Formalismus hergeleitet sind, liegen den berechneten Kurven in Fig. 4 zugrunde:

$$\Delta\phi_R = const \times \tan\frac{-2(T_{12}'/T_{12}'')}{1-2(T_{12}'/T_{12}'')^2}$$

mit

$$T_{12}^{'} = \frac{-2\varphi_F \dfrac{\tan\Gamma}{\Gamma}}{\cos\varepsilon - \delta_b \dfrac{\tan\Gamma}{\Gamma}\sin(\varepsilon)\ \sin(2\beta)}$$

und

$$\Gamma = \left[\delta_b^2 + (2\varphi_F)^2\right]^{1/2}\ .$$

Fig. 5 zeigt schematisch einen Schnitt durch einen erfindungsgemässen Sensorkopf im Bereich der Sensorfaser 3 . Die Sensorfaser 3 ist, von ihrer Faserschutzhülle befreit, in einer Kapillare gelagert, welche ausserdem noch ein Reibungsverminderungsmittel 7, beispielsweise Silikon-Öl, enthält. Durch das Reibungsverminderungsmittel 7 werden Reibungskräfte zwischen der Sensorfaser 3 und der Kapillare 6 minimiert.

Die Kapillare 6 ist in einer Nut angeordnet, welche sich entlang einer Längsachse des als Trägerkörper 11 fungierenden Kunststoffstreifens 11 erstreckt. Die Kapillare 6 ist mittels Silikon 26 in der Nut befestigt. Die Befestigung kann entlang der ganzen Sensorfaser 3 oder an diskreten Stellen vorgesehen sein. Durch die Befestigung kann ein Verdrehen der Kapillare 6 in der Nut verhindert werden.

Zur Minimierung von mechanischem Stress in der Kapillare 6 und der Sensorfaser 3 beim Biegen des Trägerkörpers 11 ist die Kapillare 6 in der neutralen Ebene 12 des Trägerkörpers 11 angeordnet. Dadurch ist gewährleistet, dass die Sensorfaser 3 nahe der neutralen Ebene 12 des Trägerkörpers 11 angeordnet ist. Mit Vorteil kann die Kapillare 6 noch eine Kapillarenummantelung aufweisen. Dadurch werden Mikrorisse, die bei häufigem Biegen des Sensorkopfes an der Oberfläche der Kapillare auftreten, vermieden. Solche Mikrorisse können zum Bruch der Kapillare führen.

Falls die Sensorfaser 3 ohne eine Kapillare an dem Streifen 11 aus glasfaserverstärktem Kunststoff angeordnet ist, wird vorteilhaft die Sensorfaser selbst in der neutralen Ebene 12 des Trägerkörpers 11 angeordnet.

Dadurch, dass die Sensorfaser 3 entlang des Einstellmittels 10 erstreckt ist, kann die Form der Spule durch das Einstellmittel 10 vorgegeben werden. Dadurch wiederum sind Änderungen der biege-induzierten Doppelbrechung bei Öffnen und Wieder-Schliessen der Spule minimierbar. Vergleiche auch oben den Beitrag (1).

Es ist auch möglich ein Einstellmittel 10 vorzusehen, das beispielsweise zwei Teilstücke aufweist, welche nahe den Enden der Sensorfaser 3 angeordnet sind und zueinander orientierbar sind, beispielsweise durch eine Steck- oder Klemmvorrichtung, während der mittlere Teil der Sensorfaser 3 keiner durch das Einstellmittel 10 vorgegebenen Form folgt. Ein drittes Teilstück des Einstellmittels dient dabei der Vorgabe der Spulenebene relativ zu den zwei anderen Teilstücken. Beispielsweise könnte das dritte Teilstück ein Gehäuse sein, das die Spulenebene vorgibt, aber die Form der Windungen innerhalb der Spulenebene im wesentlichen nicht einschränkt.

Es ist auch möglich, dass ein solches drittes Teilstück ein Gehäuse ist, das die Form der Spule innerhalb einer durch einen Kunststoffstreifen 11 als Trägerelement vorgegebenen Spulenebene vorgibt.

In solchen Fällen, wenn also veränderliche Spulenformen vorzusehen sind, kann der Beitrag (4) der biege-induzierten Doppelbrechung stark variieren zwischen der Kalibration und der Montage des Sensorkopfes am Einsatzort. Wenn also veränderliche Spulenformen vorzusehen sind, wird mit grossem Vorteil im Falle einer im Zusammenhang mit Fig. 4 beschriebenen Konfiguration ein Winkel $\beta$ von $\beta = 0° \pm n\times90°$ gewählt, wobei n eine positive ganze Zahl oder null ist. Wie Fig. 4 zu entnehmen ist, ist dann der Einfluss der biege-induzierten Doppelbrechung auf das Mess-Signal und die Kalibration minimal.

Wenn allerdings die Form der Spule bekannt und bei der Kalibration gleich ist wie am Einsatzort, beispielsweise weil ein Trägerkörper mit kompletter Fixierung der Kapillare 6 oder des Sensorfaser 3 eingesetzt wird, kann mit grossem Vorteil im Falle einer im Zusammenhang mit Fig. 4 beschriebenen Konfiguration ein Winkel $\beta$ von $\beta = 45° \pm n\times90°$ gewählt werden, um den Einfluss von nicht perfekten Fixierungen des Winkels $\beta$ zu minimieren. Wie Fig. 4 zu entnehmen ist, ist der Einfluss von $\beta$ auf das normierte Signal $S_N$ minimal, wenn $\beta = 45° \pm n\times90°$ gewählt ist.

Wie Fig. 3 zu entnehmen ist, muss für den Fall, dass das Phasenverzögerungselement keinen von einem idealen Phasenverzögerungselement abweichenden Phasenverzögerungswinkel hat (also $\varepsilon = 0°$), der für die anvisierte Anwendung optimale Winkel $\beta$ (oder $\beta$ und $\beta'$) berechnet werden.

Um den Winkel $\beta$ zu fixieren, kann entweder das Phasenverzögerungselement und/oder die Zuleitungsfaser an dem Trägerkörper 11 direkt befestigt sein, oder das Phasenverzögerungselement und/oder die Zuleitungsfaser ist an der Kapillare 6 befestigt, welche wiederum (beispielsweise durch das Silikon 26) an dem Trägerkörper 11 befestigt ist. Mit Vorteil kann ein Teil der mindestens einen Zuleitungsfaser innerhalb der Kapillare 6 angeordnet sein.

Durch die Form des Querschnitts des Trägerkörpers 11 ist eine bevorzugte Biegerichtung R (Radialrichtung) des Trägerkörpers 11 vorgegeben. Die zu der Richtung R entgegengesetzte Richtung ist ebenfalls eine bevorzugte Biegerichtung des Trägerkörpers 11. Andere Richtungen sind dadurch gekennzeichnet, dass eine deutlich grössere Kraft erforderlich ist, um den Trägerkörper entlang einer solchen Richtung (zu demselben Radius) zu biegen.

Der Querschnitt des Trägerkörpers 11 kann beispielsweise 10 mm $\times$ 2.5 mm betragen. Weitere, vorteilhaft nicht-rotationssymmetrische Querschnitte, beispielsweise elliptische, sind denkbar.

Anstelle von Epoxid-Materialien für den Trägerkörper können eine Vielzahl weiterer Materialien, wie unter anderem auch nicht-ferromagnetische Metalle, eingesetzt werden. Im Falle von Metallen muss beachtet werden, dass die Sensorfaser nicht radial komplett von Metall umschlossen wird, da sonst Wirbelströme das zu messende Magnetfeld abschirmen würden. Dies ist besonders wichtig, wenn AC-Ströme oder Ströme mit AC-Anteil beziehungsweise magnetische Wechselfelder zu messen sind.

An dem Trägerkörper 11 sind zwei Bohrungen 9a vorgesehen, welche sich nahe einem Ende des Sensorfaser 3 befinden. An dem nicht dargestellten Ende der Sensorfaser 3 ist dann mindestens eine weitere Markierung vorzusehen, beispielsweise ebenfalls Bohrungen oder passende Stifte, welche die Anordnung der Sensorfaser 3 zu einer Spule mit einer ganzzahligen Anzahl von Windungen vereinfacht, wobei die SensorfaserEnden nahe beieinander angeordnet sind. Als Markierungen können auch andere, vorzugsweise optische oder mechanische Markierungen verwendet werden. Die entsprechenden Abschnitte des Trägerkörpers 11 können dann einander überlappen oder nebeneinander angeordnet sein und durch Verschraubung oder mittels Klammern oder einer ähnlichen Haltevorrichtung zusammengehalten (aneinander fixiert) sein. Die Bohrungen 9a können auch der Fixierung des Trägerkörpers 11 an einem Gehäuse dienen. Die Form der Spule kann auch durch ein externes Gehäuse statt durch das Einstellmittel vorgegeben sein. Das Einstellmittel definiert die Winkelorientierung und nicht notwendigerweise auch die Form der Spule. Wenn die Spulenwindung(en) kreisförmig gewählt sind, ist der Einfluss von biegeinduzierter Doppelbrechung minimal.

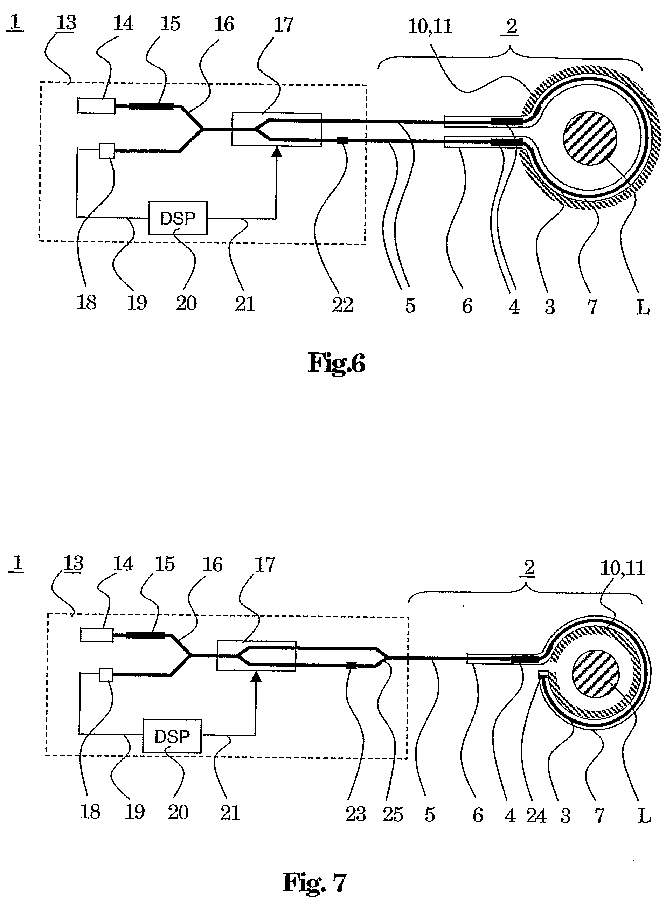

Fig. 6 zeigt schematisch einen möglichen Aufbau eines interferometrischen Sensors 1 in Sagnac-Konfiguration. Zwei Zuleitungsfasern 5 verbinden den Sensorkopf 2 mit einem optoelektronischen Modul 13, das der Lichterzeugung und -detektion und der Auswertung dient. Die Bedeutung der Bezugszeichen ist der Bezugszeichenliste zu entnehmen. Zur Erläuterung der Fig. 6 wird auf die am 3.9.2003 beim Europäischen Patentamt eingereichte Patentanmeldung mit dem Aktenzeichen EP 03405641.6 des gleichen Anmelders verwiesen. Bis auf das Einstellmittel 10 entspricht die dortige Fig. 1 im wesentlichen der vorliegenden Fig. 6. Zur Erläuterung des Sensor-Aufbaus und dessen Funktion wird auf die zugehörige Figurenbeschreibung (Seite 10 letzter Absatz bis Seite 14 erster Absatz der genannten Patentanmeldung mit dem Aktenzeichen EP 03405641.6 in der eingereichten Fassung) verwiesen. Fig. 7 zeigt schematisch einen möglichen Aufbau eines reflektiven interferometrischen Sensors 1. Die Zuleitungsfaser 5 verbindet den Sensorkopf 2 mit einem optoelektronischen Modul 13, das der Lichterzeugung und -detektion und der Auswertung dient. Die Bedeutung der Bezugszeichen ist der Bezugszeichenliste zu entnehmen. Zur Erläuterung der Fig. 7 wird auf die am 3.9.2003 beim Europäischen Patentamt eingereichte Patentanmeldung mit dem Aktenzeichen EP 03405641.6 des gleichen Anmelders verwiesen. Bis auf das Einstellmittel 10 entspricht die dortige Fig. 2 im wesentlichen der vorliegenden Fig. 7. Zur Erläuterung des Sensor-Aufbaus und dessen Funktion wird auf die zugehörige Figurenbeschreibung (Seite 14 letzter Absatz bis Seite 15 erster Absatz der genannten Patentanmeldung mit dem Aktenzeichen EP 03405641.6 in der eingereichten Fassung) verwiesen. Erfindungsgemässe Sensorköpfe und Sensoren können zur Messung grosser DC-Ströme verwendet werden, wie sie beispielsweise in der elektrochemischen Industrie oder bei elektrisch betriebenen Schmelzöfen vorkommen. Aufgrund der grossen Leiterquerschnitte sind dort grosse Spulendurchmesser erforderlich.

Ein weiteres Beispiel für eine Hochspannungsanlage, die einen erfindungsgemässen Stromsensor aufweisen kann, ist eine Hochspannungsschaltanlage, beispielsweise eine gasisolierte Schaltanlage. Vorteilhaft kann eine solche Hochspannungsanlage pro Phase oder Hochspannungsleiter je einen oder zwei Sensoren oder Sensorköpfe aufweisen.

Bezugszeichenliste

| | |
|---|---|
| 1 | Stromsensor |
| 2 | Sensorkopf |
| 3 | Sensorfaser |
| 4 | Phasenverzögerungselement, polarisationsdefinierendes Element |
| 5 | Zuleitungsfaser, polarisationsdefinierendes Element |
| 6 | Kapillare |
| 7 | Reibungsverminderungsmittel, Öl |
| 8 | Spule |
| 9a, 9b | Markierungen |
| 10 | Einstellmittel |
| 11 | Trägerkörper |

| | |
|---|---|
| 12 | neutrale Ebene des Trägerkörpers |
| 13 | optoelektronisches Modul |
| 14 | Lichtquelle, Laser, LED, Superluminszenzdiode |
| 15 | Depolarisator |
| 16 | Faserkoppler |
| 17 | Phasenmodulator |
| 18 | Detektor, Photodiode |
| 19 | Signalleitung |
| 20 | Signalprozessor |
| 21 | Steuerungsleitung |
| 22 | 0°-Faserspleiss oder Steckverbinder |
| 23 | 90°-Spleiss |
| 24 | Spiegel, verspiegeltes Ende |
| 25 | polarisationserhaltender Faserkoppler |
| 26 | Silikon |
| 27 | Fasermantel, cladding |
| 28 | Faserkern |
| 29 | Faserschutzhülle |

| | |
|---|---|
| A | Spulenebene |
| f | schnelle Achse |
| I | elektrischer Strom |
| L | Stromleiter, Stromschiene |
| Ns | Flächennormale |
| N | Anzahl Windungen der Sensorspule |
| R | bevorzugte Biegerichtung |
| $S_N$ | normiertes Signal |
| T | Temperatur |
| V | Verdet-Konstante des Sensorfaser-Materials |

| | |
|---|---|
| $\beta, \beta'$ | Winkel |
| $\delta$ | Phasenverschiebung |
| $\delta_b, \delta_0, \delta_1$ | Phasenverschiebungen |
| $\Delta\phi_R$ | strominduzierte Phasenverschiebung |

| | |
|---|---|
| $\varepsilon$ | Winkel |

| | |
|---|---|
| $\varphi_F$ | Faraday-Phasenverschiebung $V \cdot N \cdot I$ |

**Patentansprüche**

1. Faseroptischer Sensorkopf (2) für einen optischen Strom- oder Magnetfeldsensor (1), umfassend eine optische Faser, welche eine magnetooptisch aktive Sensorfaser (3) in optischer Verbindung mit mindestens einem polarisationsdefinierenden Element (4; 5) beinhaltet, wobei der Sensorkopf (2) im Bereich der Sensorfaser (3) biegbar ist, wobei die Sensorfaser (3) um einen den zu messenden Strom führenden Leiter (L) oder in einem zu messenden Magnetfeld in Form einer Spule (8) anordenbar ist, wobei durch die Spule (8) eine Spulenebene (A) mit einer Flächennormalen (Ns) definiert ist, wobei das mindestens eine polarisationsdefinierende Element (4; 5) eine ausgezeichnete Achse (f) aufweist, und wobei ein Einstellmittel (10) zur Einstellung eines vorgebbaren Winkels zwischen der ausgezeichneten Achse (f) und der Flächennormalen (Ns) oder zur Einstellung von vorgebbaren Winkeln $\beta, \beta'$ zwischen den ausgezeichneten Achsen (f) und der Flächennormalen (Ns) vorhanden ist, wobei ferner das Einstellmittel (10) einen Trägerkörper (11) beinhaltet, an dem das mindestens eine polarisationsdefinierende Element (4; 5) fixiert ist,
**dadurch gekennzeichnet, dass**
die Sensorfaser (3) eine nicht bei mindestens der Erweichungstemperatur des Sensorfasermaterials thermisch behandelte Faser ist, die Sensorfaser (3) von ihrer Faserschutzhülle befreit ist,
die Sensorfaser (3) in einer Kapillare (6) gelagert ist,
die Kapillare (6) ein Reibungsverminderungsmittel (7) enthält und

der Trägerkörper (11) ein flexibel verformbarer Trägerkörper (11) ist.

2. Sensorkopf (2) gemäss Anspruch 1, **dadurch gekennzeichnet, dass** das Einstellmittel (10) vorgesehen ist, um, indem durch das Einstellmittel (10) der Winkel β reproduzierbar einstellbar ist oder die Winkel β,β' reproduzierbar einstellbar sind, eine Reproduzierbarkeit einer Gesamt-Doppelbrechung der Sensorfaser (3) zu erreichen, wenn die Sensorfaser (3) nach einer Kalibration des Strom- oder Magnetfeldsensors und vor einer Montage der Spule (8) an einem Einsatzort in eine andere Form gebracht wird.

3. Sensorkopf (2) gemäss Anspruch 2, **dadurch gekennzeichnet, dass** die Gesamt-Doppelbrechung sich im wesentlichen aus folgenden Beiträgen zusammensetzt:

   - Biegungs-induzierte Doppelbrechung,
   - Intrinsische Doppelbrechung durch internen Stress in der Sensorfaser (3) und durch eine nicht-perfekt rotationssymmetrische Form des Faserkerns der Sensorfaser (3),
   - Stress an Faserspleissen des Sensorkopfes (2), und
   - Doppelbrechung dadurch, dass die Sensorfaser (3) in entspanntem Zustand eine Vorkrümmung aufweist.

4. Sensorkopf (2) gemäss einem der vorangegangenen Ansprüche, **dadurch gekennzeichnet, dass** das mindestens eine polarisationsdefinierende Element (4;5) mindestens ein Polarisator oder mindestens ein Phasenverzögerungselement (4) oder mindestens eine polarisationserhaltenden Zuleitungsfaser (5) ist.

5. Sensorkopf (2) gemäss Anspruch 1, **dadurch gekennzeichnet, dass** der Trägerkörper (11) derart ausgebildet ist, dass durch ihn und die Fixierung des polarisationsdefinierenden Elementes (4;5) die relative Lage der ausgezeichneten Achse (f) oder Achsen (f) bezüglich der Spulenebene (A) festgelegt ist.

6. Sensorkopf (2) gemäss einem der Ansprüche 1 oder 5, **dadurch gekennzeichnet, dass** die Sensorfaser (3) entlang einer Längsachse des Trägerkörpers (11) erstreckt ist, und dass eine bevorzugte Biegerichtung (R) des Trägerkörpers (11) senkrecht zu der Längsachse vorgegeben ist.

7. Sensorkopf (2) gemäss Anspruch 6, **dadurch gekennzeichnet, dass** bei Biegung des Trägerkörpers (11) in die bevorzugte Biegerichtung (R) die Sensorfaser (3) in oder nahe der neutralen Ebene (12) des Trägerkörpers (11) angeordnet ist.

8. Sensorkopf (2) gemäss Anspruch 1, **dadurch gekennzeichnet, dass** als Trägerkörper (11) ein Streifen aus glasfaserverstärktem Kunststoff dient.

9. Sensorkopf (2) gemäß einem der Ansprüche 1 oder 8, **dadurch gekennzeichnet, dass** die Kapillare (6) in einer Nut angeordnet ist, welche sich entlang einer Längsachse eines als Trägerkörper (11) fungierenden Kunststoffstreifens erstreckt.

10. Sensorkopf (2) gemäß Anspruch 9, **dadurch gekennzeichnet, dass** die Kapillare (6) mittels Silikon (26) in der Nut befestigt ist.

11. Sensorkopf (2) gemäß Anspruch 10, **dadurch gekennzeichnet, dass** die Befestigung entlang der ganzen Sensorfaser (3) oder an diskreten Stellen vorgesehen ist.

12. Sensorkopf (2) gemäß einem der vorangehenden Ansprüche, **dadurch gekennzeichnet, dass** das Reibungsverminderungsmittel (7) in der Kapillare (6) Silikon-Öl ist.

13. Sensorkopf (2) gemäss einem der Ansprüche 1-7, **dadurch gekennzeichnet, dass** der Winkel oder die Winkel β,β' in Abhängigkeit

   - von intrinsischer Doppelbrechung der Sensorfaser und Doppelbrechung an Spleissen,
   - von biegungs-induzierter Doppelbrechung
   - von Doppelbrechung aufgrund einer Vorkrümmung der Sensorfaser, und

derart gewählt ist oder gewählt sind, dass

- der Einfluss von Änderungen der biegungs-induzierten Doppelbrechung oder
- der Einfluss von Änderungen des Winkels beziehungsweise der Winkel $\beta,\beta'$

auf Mess-Signale, die von einem Strom- oder Magnetfeldsensor mit dem Sensorkopf (2) erzeugbar sind, minimal ist.

14. Sensorkopf (2) gemäss Anspruch 13, **dadurch gekennzeichnet, dass** die Sensorfaser (3) im wesentlichen in der Spulenebene (A) angeordnet ist, und

- dass das polarisationsdefinierende Element (5) eine polarisationserhaltende Zuleitungsfaser (5) ist, und wobei zwischen der polarisationserhaltenden Zuleitungsfaser (5) und der Sensorfaser (3) ein Phasenverzögerungselement (4) angeordnet ist, welches einen Phasenverzögerungswinkel aufweist, der von dem Phasenverzögerungswinkel eines idealen Phasenverzögerungselementes um einen von null verschiedenen Winkel $\varepsilon$ abweicht, und wobei der Winkel $\beta$ als $\beta = 0° \pm n\times90°$ oder als $\beta = 45° \pm n\times90°$ gewählt ist, wobei n eine positive ganze Zahl oder null ist, oder
- dass die polarisationsdefinierenden Elemente (5) zwei Zuleitungsfasern (5) sind, und wobei zwischen den Zuleitungsfasern (5) und der Sensorfaser (3) jeweils ein Phasenverzögerungselement (4) angeordnet ist, wobei mindestens eines der beiden Phasenverzögerungselemente (4) einen Phasenverzögerungswinkel aufweist, der von dem Phasenverzögerungswinkel eines idealen Phasenverzögerungselementes um einen von null verschiedenen Winkel $\varepsilon$ abweicht, und wobei die Winkel $\beta,\beta'$ als $\beta = \beta' = 0° \pm n\times90°$ oder als $\beta = \beta' = 45° \pm n\times90°$ gewählt sind, wobei n eine positive ganze Zahl oder null ist.

15. Sensorkopf (2) gemäss einem der Ansprüche 1-7 und 13-14, **dadurch gekennzeichnet, dass** Markierungen (9a,9b) vorhanden sind, die derart an dem Einstellmittel (10) angebracht sind, dass die Spule (8) eine ganze Anzahl von Windungen aufweist, wenn die Markierungen (9a,9b) in geeigneter Weise zueinander angeordnet sind.

16. Strom- oder Magnetfeldsensor (1) **dadurch gekennzeichnet, dass** der Sensor (1) einen Sensorkopf (2) gemäss einem der vorangegangenen Ansprüche aufweist.

17. Strom- oder Magnetfeldsensor (1) gemäss Anspruch 16, **dadurch gekennzeichnet, dass** der Sensor (1)

a) ein interferometrischer Sensor (1) in Reflexionskonfiguration ist mit einer polarisationserhaltenden Zuleitungsfaser (5) als dem einen polarisationsdefinierenden Element (5), und wobei die eine ausgezeichnete Achse (f) eine der Hauptachsen (f) der Zuleitungsfaser (5) ist, oder
b) ein interferometrischer Sensor in Sagnac-Konfiguration ist mit zwei polarisationserhaltenden Zuleitungsfasern (5) als polarisationsdefinierenden Elementen (5), und wobei die zwei ausgezeichneten Achsen (f) jeweils eine der Hauptachsen (f) der zwei Zuleitungsfasern (5) sind, oder
c) ein polarimetrischer Sensor in Reflexionskonfiguration ist mit einem Polarisator als polarisationsdefinierendem Element oder mit einer polarisationserhaltenden Zuleitungsfasern als polarisationsdefinierendem Element, und wobei die eine ausgezeichnete Achse entlang der Transmissionsrichtung des Polarisators beziehungsweise entlang einer Hauptachse der polarisationserhaltenden Zuleitungsfaser verläuft, oder
d) ein polarimetrischer Sensor in Sagnac-Konfiguration ist mit zwei Polarisatoren als polarisationsdefinierenden Elementen oder mit zwei polarisationserhaltenden Zuleitungsfasern als polarisationsdefinierenden Elementen, und wobei die zwei ausgezeichneten Achsen entlang der Transmissionsrichtungen der zwei Polarisatoren beziehungsweise entlang der Hauptachsen der polarisationserhaltenden Zuleitungsfasern verlaufen.

18. Hochspannungsanlage, insbesondere Hochspannungsschaltanlage, **dadurch gekennzeichnet, dass** sie mindestens einen Sensorkopf (2) gemäss einem der Ansprüche 1 bis 15 aufweist.

19. Verfahren zur Herstellung eines Sensorkopfes (2) für einen optischen Strom- oder Magnetfeldsensor (1), wobei eine magnetooptisch aktive Sensorfaser (3), die in optischer Verbindung mit mindestens einem polarisationsdefinierenden Element (4; 5) steht, in Form einer Spule (8) angeordnet wird, wobei als Sensorfaser (3) eine nicht bei mindestens der Erweichungstemperatur des Sensorfasermaterials thermisch behandelte Faser verwendet wird, wobei durch die Spule (8) eine Spulenebene (A) mit einer Flächennormalen ($N_S$) definiert ist, wobei das polarisationsdefinierende Element (4; 5) eine ausgezeichnete Achse (f) aufweist, und wobei eine Kalibrierung des mit der spulenförmig angeordneten Sensorfaser (3) versehenen Strom- oder Magnetfeldsensors (1) vorgenommen wird, und dass der Sensorkopf (2) mit einem Einstellmittel (10) versehen wird, durch welches bei einem erneuten Anordnen der Sensorfaser (3) zu einer Spule (8) der Winkel $\beta$ zwischen der ausgezeichneten Achse (f) und der Flächennormalen ($N_S$) gleich gross einstellbar ist wie während der Kalibrierung, wobei das Einstellmittel (10) einen Trägerkörper (11) beinhaltet, an dem das mindestens eine polarisationsdefinierende Element (4; 5) fixiert ist, **dadurch gekennzeichnet, dass**
die Sensorfaser (3) von ihrer Faserschutzhülle befreit wird,
die Sensorfaser (3) in einer Kapillare (6) gelagert wird, die Kapillare (6) ein Reibungsverminderungsmittel (7) enthält und der Trägerkörper (11) ein flexibel verformbarer Trägerkörper (11) ist.

**Claims**

1.  Fiber-optic sensor head (2) for an optical current or magnetic-field sensor (1), having an optical fiber which includes a magnetooptically active sensor fiber (3) which is optically connected to at least one polarization-defining element (4; 5), with the sensor head (2) being flexible in the area of the sensor fiber (3), in which the sensor fiber (3) can be arranged around a conductor (L) which carries the current to be measured or in a magnetic field, to be measured, in the form of a coil (8), with the coil (8) defining a coil plane (A) with a surface normal ($N_S$), with the at least one polarization-defining element (4; 5) having a marked axis (f), and with an adjustment means (10) being provided for adjustment of a predeterminable angle β between the marked axis (f) and the surface normal ($N_S$) or for adjustment of predeterminable angles β, β' between the marked axes (f) and the surface normal ($N_S$), furthermore with the adjustment means (10) containing a mount body (11), to which the at least one polarization-defining element (4; 5) is fixed, **characterized in that**
    the sensor fiber (3) is a fiber which has not been thermally treated at at least the softening temperature of the sensor fiber material,
    the fiber coating has been removed from the sensor fiber (3),
    the sensor fiber (3) is mounted in a capillary (6),
    the capillary (6) contains a friction-reducing means (7), and
    the mount body (11) is a flexibly deformable mount body (11).

2.  Sensor head (2) according to Claim 1, **characterized in that** the adjustment means (10) is provided in order to achieve reproducibility of overall birefringence of the sensor fiber (3), **in that** the adjustment means (10) can be used to set the angle β reproducibly or to set the angles β, β' reproducibly, when the sensor fiber (3) is changed to a different shape after calibration of the current or magnetic-field sensor and before installation of the coil (8) at a usage location.

3.  Sensor head (2) according to Claim 2, **characterized in that** the overall birefringence is made up essentially of the following contributions:

    - bending-induced birefringence,
    - intrinsic birefringence as a result of internal stress in the sensor fiber (3) and as a result of the fiber core of the sensor fiber (3) not having a perfectly rotationally symmetrical shape,
    - stress at fiber splices in the sensor head (2) and
    - birefringence resulting from the fact that the sensor fiber (3) has initial curvature in the unstressed state.

4.  Sensor head (2) according to one of the preceding claims, **characterized in that** the at least one polarization-defining element (4; 5) is at least one polarizer or at least one phase-delay element (4), or at least one polarization-maintaining supply fiber (5).

5.  Sensor head (2) according to Claim 1, **characterized in that** the mount body (11) is designed in such a manner that it and the fixing of the polarization-defining element (4; 5) define the relative position of the marked axis (f) or axes (f) with respect to the coil plane (A).

6.  Sensor head (2) according to one of Claims 1 or 5, **characterized in that** the sensor fiber (3) extends along a longitudinal axis of the mount body (11), and **in that** a preferred bending direction (R) of the mount body (11) is predetermined at right angles to the longitudinal axis.

7.  Sensor head (2) according to Claim 6, **characterized in that**, when the mount body (11) is bent in the preferred bending direction (R), the sensor fiber (3) is arranged on or close to the neutral plane (12) of the mount body (11).

8.  Sensor head (2) according to Claim 1, **characterized in that** a strip of glass-fiber-reinforced plastic is used as the mount body (11).

**9.** Sensor head (2) according to one of Claims 1 or 8, **characterized in that** the capillary (6) is arranged in a groove which extends along a longitudinal axis of a plastic strip which acts as the mount body (11).

**10.** Sensor head (2) according to Claim 9, **characterized in that** the capillary (6) is mounted in the groove by means of silicone (26).

**11.** Sensor head (2) according to Claim 10, **characterized in that** the attachment is provided along the entire sensor fiber (3) or at discrete points.

**12.** Sensor head (2) according to one of the preceding claims, **characterized in that** the friction-reducing means (7) in the capillary (6) is silicone oil.

**13.** Sensor head (2) according to one of Claims 1-7, **characterized in that** the angle β or the angles β, β' is or are chosen as a function

- of the intrinsic birefringence of the sensor fiber, and birefringence at splices,
- of bending-induced birefringence,
- of birefringence resulting from initial curvature of the sensor fiber, and

in such a manner that

- the influence of changes in the bending-induced birefringence or
- the influence of changes in the angle β or in the angles β, β'

on measurement signals which can be produced by a current or magnetic-field sensor with the sensor head (2) is minimal.

**14.** Sensor head (2) according to Claim 13, **characterized in that** the sensor fiber (3) is arranged essentially on the coil plane (A), and

- **in that** the polarization-defining element (5) is a polarization-maintaining supply fiber (5), with a phase-delay element (4) being arranged between the polarization-maintaining supply fiber (5) and the sensor fiber (3) and having a phase delay angle which differs from the phase-delay angle of an ideal phase-delay element by an angle ε other than zero, and with the angle β being chosen to be β = 0° ± n×90° or β = 45° ± n×90°, where n is a positive integer or is zero, or
- **in that** the polarization-defining elements (5) are two supply fibers (5), with a phase-delay element (4) in each case being arranged between the supply fibers (5) and the sensor fiber (3), with at least one of the two phase-delay elements (4) having a phase-delay angle which differs from the phase-delay angle of an ideal phase-delay element by an angle ε other than zero, and with the angles β, β' being chosen to be β = β' = 0° ± n×90° or β = β' = 45° ± n×90°, where n is a positive integer or is zero.

**15.** Sensor head (2) according to one of Claims 1-7 and 13-14, **characterized in that** markings (9a, 9b) are provided, and are fitted to the adjustment means (10) in such a manner that the coil (8) has an integer number of turns when the markings (9a, 9b) are arranged in a suitable manner with respect to one another.

**16.** Current or magnetic-field sensor (1), **characterized in that** the sensor (1) has a sensor head (2) according to one of the preceding claims.

**17.** Current or magnetic-field sensor (1) according to Claim 16, **characterized in that** the sensor (1)

a) is an interferometric sensor (1) in a reflection configuration with a polarization-maintaining supply fiber (5) as one polarization-defining element (5), and with one marked axis (f) being one of the principle axes (f) of the supply fiber (5), or
b) is an interferometric sensor in the Sagnac configuration with two polarization-maintaining supply fibers (5) as polarization-defining elements (5), and with the two marked axes (f) each being one of the principle axes (f) of the two supply fibers (5), or
c) is a polarimetric sensor in a reflection configuration with a polarizer as the polarization-defining element or with a polarization-maintaining supply fiber as the polarization-defining element, and with one marked axis running along the transmission direction of the polarizer or along a principal axis of the polarization-maintaining supply fiber, or

d) is a polarimetric sensor in the Sagnac configuration with two polarizers as polarization-defining elements or with two polarization-maintaining supply fibers as polarization-defining elements, and with the two marked axes running along the transmission directions of the two polarizers or along the principal axes of the polarization-maintaining supply fibers.

**18.** High-voltage installation, in particular high-voltage switchgear assembly, **characterized in that** the installation has at least one sensor head (2) according to one of Claims 1 to 15.

**19.** Method for production of a sensor head (2) for an optical current or magnetic-field sensor (1), with a magnetooptically active sensor fiber (3), which is optically connected to at least one polarization-defining element (4; 5), being arranged in the form of a coil (8), with a fiber which has not been thermally treated at at least the softening temperature of the sensor fiber material being used as the sensor fiber (3), with the coil (8) defining a coil plane (A) with a surface normal ($N_S$), with the polarization-defining element (4; 5) having a marked axis (f), and with the current or magnetic-field sensor (1) which is provided with the sensor fiber (3) arranged in the form of a coil being calibrated, and in that the sensor head (2) is provided with an adjustment means (10) by means of which, when the sensor fiber (3) is arranged with respect to a coil (8) again, the angle $\beta$ between the marked axis (f) and the surface normal ($N_S$) can be adjusted to be of the same magnitude as during the calibration, wherein the adjustment means (10) contains a mount body (11) to which the at least one polarization-defining element (4; 5) is fixed, **characterized in that**
the fiber coating has been removed from the sensor fiber (3),
the sensor fiber (3) is mounted in a capillary (6),
the capillary (6) contains a friction-reducing means (7), and
the mount body (11) is a flexibly deformable mount body (11).

## Revendications

**1.** Tête de capteur (2) à fibre optique destinée à un capteur optique de courant ou de champ magnétique (1), comprenant une fibre optique qui contient une fibre de détection (3) magnéto-optique active en liaison optique avec au moins un élément (4 ; 5) définissant la polarisation, dans lequel la tête de capteur (2) peut être incurvée dans la région de la fibre de détection (3), dans lequel la fibre de détection (3) peut être disposée autour d'un conducteur (L) conduisant un courant à mesurer ou dans un champ magnétique à mesurer sous la forme d'une bobine (8), dans lequel un plan de bobine (A) ayant une normale à la surface ($N_S$) est défini par la bobine (8), dans lequel l'au moins un élément (4 ; 5) définissant la polarisation présente un axe (f) caractérisé, et dans lequel il est prévu un moyen de réglage (10) destiné à régler un angle $\beta$ pouvant être prédéterminé entre l'axe (f) caractérisé et la normale à la surface ($N_S$) ou à régler des angles, $\beta$, $\beta'$ pouvant être prédéterminés entre les axes (f) caractérisés et les normales aux surfaces ($N_S$), dans lequel le moyen de réglage (10) contient en outre un corps de support (11) auquel est fixé l'au moins un élément (4 ; 5) définissant la polarisation,
**caractérisé en ce que** la fibre de détection (3) est une fibre non traitée thermiquement à au moins la température de fusion du matériau de la fibre de détection,
la fibre de détection (3) est dépourvue de sa gaine de protection de fibre,
la fibre de détection (3) est positionnée dans un tube capillaire (6),
le tube capillaire (6) contient un agent de réduction du frottement (7), et
le corps de support (11) est un corps de support (11) flexible déformable.

**2.** Tête de capteur (2) selon la revendication 1, **caractérisée en ce que** le moyen de réglage (10) est prévu pour atteindre une reproductibilité d'une biréfringence globale de la fibre de détection (3) en raison du fait que l'angle $\beta$ est réglable de manière reproductible par le moyen de réglage (10) ou que les angles $\beta, \beta'$ sont réglables de manière reproductible, lorsque la fibre de détection (3) est mise sous une autre forme sur son lieu d'utilisation après un étalonnage du capteur de courant ou de champ magnétique et avant le montage de la bobine (8).

**3.** Tête de capteur (2) selon la revendication 2, **caractérisée en ce que** la biréfringence globale se compose sensiblement des contributions suivantes :

- biréfringence induite par courbure,
- biréfringence intrinsèque due à une contrainte interne dans la fibre de détection (3) et du fait d'une forme non parfaitement symétrique de rotation de l'âme de la fibre de détection (3),
- contrainte au niveau des épissures de fibre de la tête de capteur (2), et
- biréfringence due au fait que la fibre de détection (3) présente à l'état détendu une courbure préalable.

4. Tête de capteur (2) selon l'une des revendications précédentes, **caractérisée en ce que** l'au moins un élément (4 ; 5) définissant la polarisation est au moins un polariseur ou au moins un élément de retard de phase (4) ou au moins une fibre d'amenée (5) à maintien de polarisation.

5. Tête de capteur (2) selon la revendication 1, **caractérisée en ce que** le corps de support (11) est réalisé de manière à ce que la position relative de l'axe (f) ou des axes (f) caractérisé (s) par rapport au plan de bobine (A) soit fixée par lui-même et par la fixation de l'élément (4 ; 5) définissant la polarisation.

6. Tête de capteur (2) selon les revendications 1 ou 5, **caractérisée en ce que** la fibre de détection (3) s'étend le long d'un axe longitudinal du corps de support (11) et **en ce qu'**une direction de courbure préférée (R) du corps de support (11) est prédéfinie perpendiculairement à l'axe longitudinal.

7. Tête de capteur (2) selon la revendication 6, **caractérisée en ce que** la fibre de détection (3) est disposée dans le plan neutre (12) du corps de support (11) ou à proximité de celui-ci lors de la courbure du corps de support (11) dans la direction de courbure (R) préférée.

8. Tête de capteur (2) selon la revendication 1, **caractérisée en ce qu'**une bande constituée de matière plastique renforcée par des fibres de verre est utilisée en tant que corps de support (11).

9. Tête de capteur (2) selon l'une quelconque des revendications 1 ou 8, **caractérisée en ce que** le tube capillaire (6) est disposé dans une encoche qui s'étend le long d'un axe longitudinal d'une bande de matière plastique jouant le rôle de bord de support (11).

10. Tête de capteur (2) selon la revendication 9, **caractérisée en ce que** le tube capillaire (6) est fixé dans l'encoche par de la silicone (26).

11. Tête de capteur (2) selon la revendication 10, **caractérisée en ce que** la fixation est prévue le long de la totalité de la fibre de capteur (3) ou en des points discrets.

12. Tête de capteur (2) selon l'une quelconque des revendications précédentes, **caractérisée en ce que** l'agent de réduction du frottement (7) se trouvant dans le tube capillaire (6) est une huile de silicone.

13. Tête de capteur (2) selon l'une quelconque des revendications 1 - 7, **caractérisée en ce que** l'angle $\beta$ ou les angles $\beta,\beta'$ est ou sont sélectionné (s) en fonction

   - de la biréfringence intrinsèque de la fibre de détection et de la biréfringence au niveau des épissures,
   - de la biréfringence induite par courbure,
   - de la biréfringence due à une courbure préalable de la fibre de détection, et

de manière à ce que

   - l'influence de modifications de la biréfringence induite par flexion, ou
   - l'influence de modifications de l'angle $\beta$ ou des angles $\beta'\beta'$,

soit minimale sur les signaux de mesure qui peuvent être générés par un capteur de courant ou de champ magnétique à l'aide de la tête de capteur (2).

14. Tête de capteur (2) selon la revendication 13, **caractérisée en ce que** la fibre de détection (3) est sensiblement disposée dans le plan de bobine (A), et

   - **en ce que** l'élément (5) définissant la polarisation est une fibre d'amenée (5) à maintien de polarisation, et dans lequel un élément de retard de phase (4) est disposé entre la fibre d'amenée (5) à maintien de polarisation et la fibre de détection (3), lequel élément de retard de phase présente un angle de retard de phase qui s'écarte de l'angle de retard de phase d'un élément de retard de phase idéal d'un angle $\varepsilon$ différent de 0, et dans lequel l'angle β est sélectionné de manière à ce que β = 0° ± n×90° ou à ce que β = 45° ± n×90°, dans lequel n est un nombre entier positif ou nul, ou

- **en ce que** les éléments (5) définissant la polarisation sont deux fibres d'amenée (5), et dans lequel un élément de retard de phase (4) est disposé entre les fibres d'amenée (5) et la fibre de détection (3), dans lequel au moins l'un des deux éléments de retard de phase (4) présente un angle de retard de phase qui s'écarte de l'angle de retard de phase d'un élément de retard de phase idéal d'un angle ε différent de 0, et dans lequel les angles β,β' sont sélectionnés de manière à ce que β = 0° ± n×90° ou à ce que β = β' = 45° ± n×90°, dans lequel n est un nombre entier positif ou nul.

15. Tête de capteur (2) selon l'une quelconque des revendications 1 - 7 et 13 - 14, **caractérisée en ce qu'**il est prévu des repères (9a, 9b) qui sont appliqués au moyen de réglage (10) de manière à ce que la bobine (8) présente un nombre entier d'enroulements lorsque les repères (9a, 9b) sont agencés de manière appropriée les uns par rapport aux autres.

16. Capteur de courant ou de champ magnétique (1), **caractérisé en ce que** le capteur (1) comporte une tête de capteur (2) selon l'une quelconque des revendications précédentes.

17. Capteur de courant ou de champ magnétique (1) selon la revendication 16, **caractérisé en ce que** le capteur (1) est

a) un capteur interférométrique (1) en configuration de réflexion comportant une fibre d'amenée (5) à maintien de polarisation en tant que ledit un élément (5) définissant la polarisation, et dans lequel ledit axe (f) caractérisé est un axe principal (f) de la fibre d'amenée (5), ou

b) est un capteur interférométrique en configuration de Sagnac comportant deux fibres d'amenée (5) à maintien de polarisation en tant qu'éléments (5) définissant la polarisation, et dans lequel les deux axes (f) caractérisés sont respectivement l'un des axes principaux (f) des deux fibres d'amenée (5), ou

c) est un capteur polarimétrique en configuration de réflexion comportant un polariseur en tant qu'élément définissant la polarisation ou comportant une fibre d'amenée à maintien de polarisation en tant qu'élément définissant la polarisation, et dans lequel ledit axe caractérisé s'étend le long de la direction de transmission du polariseur ou le long d'un axe principal de la fibre d'amenée à maintien de polarisation, ou

d) est un capteur polarimétrique en configuration de Sagnac comportant deux polariseurs en tant qu'éléments définissant la polarisation ou comportant deux fibres d'amenée à maintien de polarisation en tant qu'éléments définissant la polarisation, et dans lequel les deux axes caractéristiques s'étendent le long des directions de transmission des deux polariseurs ou le long des axes principaux des fibres d'amenée à maintien de polarisation.

18. Installation à haute tension, notamment installation de commutation à haute tension, **caractérisée en ce qu'**elle comporte au moins une tête de capteur (2) selon l'une quelconque des revendications 1 à 15.

19. Procédé de fabrication d'une tête de capteur (2) destinée à un capteur optique de courant ou de champ magnétique (1), dans lequel une fibre de détection (3) magnéto-optique active, qui est en liaison optique avec au moins un élément (4 ; 5) définissant la polarisation, est disposée sous la forme d'une bobine (8), dans lequel une fibre non traitée thermiquement à au moins la température de fusion du matériau de la fibre de détection est utilisée en tant que fibre de détection (3), dans lequel un plan de bobine (A) ayant une normale à la surface ($N_S$) est défini par la bobine (8), dans lequel l'élément (4 ; 5) définissant la polarisation présente un axe caractérisé (f), et dans lequel un étalonnage du capteur de courant ou de champ magnétique (1) muni de la fibre de détection (3) disposée sous la forme d'une bobine est effectué, et en ce que la tête de capteur (2) est munie d'un moyen de réglage (10) à l'aide duquel l'angle β entre l'axe caractérisé (f) et la normale à la surface ($N_S$) peut être réglé à une valeur aussi élevée que pendant l'étalonnage lorsque la fibre de détection (3) est à nouveau disposée sur une bobine (8), dans lequel le moyen de réglage (10) contient un corps de support (11) auquel est fixé l'au moins un élément (4 ; 5) définissant la polarisation, **caractérisé en ce que**

la fibre de détection (3) est dépourvue de sa gaine de protection de fibre,

la fibre de détection (3) est positionnée dans un tube capillaire (6),

le tube capillaire (6) contient un agent de réduction du frottement (7), et

le corps de support (11) est un corps de support (11) flexible déformable.

$N_S$

β

f

2

A

9b

24

f

f

s

8

3

10,11    5    4

9a

L

**Fig. 1**

$N_S$

β

s

f

27

28

f

29

s

**Fig. 2**

**Fig. 3**

**Fig. 4**

9a   26   R   6   7   3   9a   10,11   12

**Fig. 5**

**Fig.6**

**Fig. 7**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 2001083187 A
- JP 2001121675 A
- JP 09068618 A
- EP 1115000 A
- WO 03071290 A1
- EP 03405641 A